# EUROPEAN PATENT APPLICATION

(11) **EP 2 845 919 A1**
(43) Date of publication of application: **11.03.2015**
(21) Application number: 14183124.8
(22) Date of filing: 02.09.2014
(51) Int. Cl.: C23C 14/06, C01B 31/04, C23C 16/26

(54) **A home appliance having an anti-corrosion coating**

(30) Priority: 03.09.2013 TR 201310404
(71) Applicant: BSH Bosch und Siemens Hausgeräte GmbH, 81739 München (DE)
(72) Inventor: Duran, Hüseyin Caner, 34513 Istanbul (TR); Karahasanoglu, Cansu, 34740 Istanbul (TR); Yücel, Murat, 59850 Tekirdag (TR)
(74) Representative: Richter, Harald

(57) **Abstract**

The invention is a home appliance (1), and particularly a cooling device having metal materials (20) in metal plate (201) form or in metal piece (202) form. The present invention is characterized in that the metal materials (20) of the home appliance comprise at least one graphene layer (30) coated onto the at least one surface of said metal material (20) and made of carbon atoms (31). Thus, the sections of the home appliance (1), which are made of metal materials (20), are protected against rusting which occurs due to the humidity in air and due to the humidity occurring after condensation.

## Description

The invention is related to a home appliance and particularly a cooling device having a body; and metal plates forming an inner liner of the body or forming an outer liner comprising a front, lateral and rear panel. The present invention particularly relates to coating of the home appliance and coating of metal materials, like metal pieces and metal plates, by means of coating materials against corrosion.

### KNOWN STATE OF THE ART

In the present art, there are home appliances having metal pieces and metal plates forming an inner liner of the body or forming an outer liner comprising a front, lateral and rear panel.

When the structure and the operation principles of a home appliance like a cooling device are taken into consideration, it is observed that these are affected by the inner and outer humid air in the ambient. Particularly in devices having freezer and cooler, condensation occurs as a result of the effect of the contact of cold air and hot air. Even if the inner section of the cooling device is desired to be cooled by means of a cooling gas and even if said inner section is desired to be drought, dry and cool; the foods, placed inside the cooler or freezer, lead to humidity in the ambient. The humidity inside the inner liner may occur as a result of the food placed into the cooler, and the humidity on the panels of the outer liner may occur as a result of the condensation occurring due to the cooling cycle. The humidity, accumulated on the metal sections like metal plate and metal piece, leads to corrosion by time.

Some metal sections of the home appliance, particularly the visible metal sections of the home appliance are painted by means of paint. However, as a result of the humidity in the ambient, the paint may get removed from the fixture by time. Afterwards, rusting occurs on these sections. The metal plate sections may be galvanize-coated.

In the known present condition of the art, there are patents which are related to the coatings functioning as a protective against rusting.

One of these is the patent application with title "Embedded-cooler" and with publication number TR199902392. In this application, an embedded-cooler is disclosed, and there is a heat-insulated body, and there is at least one heat-insulated door. There are structure members, made of metal structure members, in both of them. This patent application is characterized in that in the final condition, the visible outer surfaces of the metal members are equipped with a decorative layer, and the other sections, which are not visible in the installed condition, bear a main coating functioning as a protective against rusting.

One of the examples is the patent application with title "Protective carbon coatings" and with publication number US20100203340. In the abstract section of the present invention, in order to form a protective coating and for providing a carbon material to be connected to a metal surface, the following are disclosed: heating of carbon and metal material; dissolving of at least one section of the carbon material in metal; permitting penetration thereof to the metal surface; and cooling of the metal material.

### BRIEF DESCRIPTION OF THE INVENTION

The object of the present invention is to prevent rusting of the metal plates and metal pieces used in forming of a home appliance; and to provide long life to said metal plates and metal pieces.

In order to realize the abovementioned objects and the objects which are to be deducted from the detailed description below, the present invention is a home appliance, and particularly a cooling device having metal materials in metal plate form or in metal piece form. The metal materials of the home appliance comprise at least one graphene layer coated onto the at least one surface of said metal material and made of carbon atoms. Thus, for the sections of the home appliance which are made of metal materials, an anti-corrosion coating is provided for providing protection against rusting occurring due to the humidity in the air and due to the humidity occurring after condensation.

In possible embodiments of the present invention, metal materials in the form of metal plate or metal piece may form the visible or invisible sections of the home appliance.

In a possible embodiment of the present invention, the graphene layer comprises six carbon atom arrangements with hexagonal shape and having one each bonds in between the carbon atoms. Thus, perfectly arranged, rigid and stable layer structure is formed for providing resistance against corrosion.

In another possible embodiment of the present invention, the metal material comprises a multi-layer graphene layer. Thus, the number of protective layers provided on the metal material can be increased. Since the graphene layer will be transparent, the aesthetic appearance of the metal sections of the home appliance will be preserved.

In another possible embodiment of the present invention, the metal materials are the metal plates forming an inner liner of the home appliance. Thus, any desired main section of the home appliance is made of metal material, and resistance and aesthetic appearance thereof are provided.

In another possible embodiment of the present invention, the metal materials are the metal plates forming an outer liner of the home appliance. Thus, any desired main section of the home appliance is made of metal materials, and the resistance and aesthetic appearance thereof are improved.

In another possible embodiment of the present invention, the metal material is a metal piece forming the sections of the home appliance, for example, a hinge or a decorative panel. Thus, any desired secondary section of the home appliance is made of metal material, and the resistance and aesthetic appearance thereof are improved.

The present invention is a home appliance production method and particularly a cooling device production method having metal materials in metal plate or metal piece form. In order to provide an efficient stainlessness to metal materials, at least one surface of the metal material is coated with at least one graphene layer. Thus, the sections of the home appliance made of metal materials are protected against rusting which occurs due to the humidity in air and due to the humidity occurring after condensation.

In a possible production method of the present invention, in the method for obtaining a metal material coated with graphene layer, there are the process steps of obtaining carbon atoms in gas form by heating the ambient air, heating the surface of the metal material, providing the carbon atoms to be held by precipitating carbon atoms onto the surface of the metal material in the same ambient, and by means of one each bond in between the carbon atoms.

In another possible production method of the present invention, the ambient air, where the carbon atoms and metal material are provided, is heated to a temperature between 650 and 1000 °C.

In a probable production method of the present invention, for the ambient air, a closed atmosphere is provided inside a chemical vapor precipitation unit.

In another possible production method of the present invention, it comprises the process step of cooling the surface of the metal material.

In a probable production method of the present invention, the cooling process is realized in the form of stepped cooling.

### BRIEF DESCRIPTION OF THE FIGURES

Figure-1 shows a frontal perspective view where an inner liner and doors of the home appliance are visible.
Figure-2 shows a frontal perspective view where an outer liner of the sections of a different type of home appliance, which comprise metal plates, can be viewed.
Figure-3 shows the view of a graphene layer provided on a metal material surface.
Figure-4 shows the view of a single graphene layer.

### DETAILED DESCRIPTION OF THE INVENTION

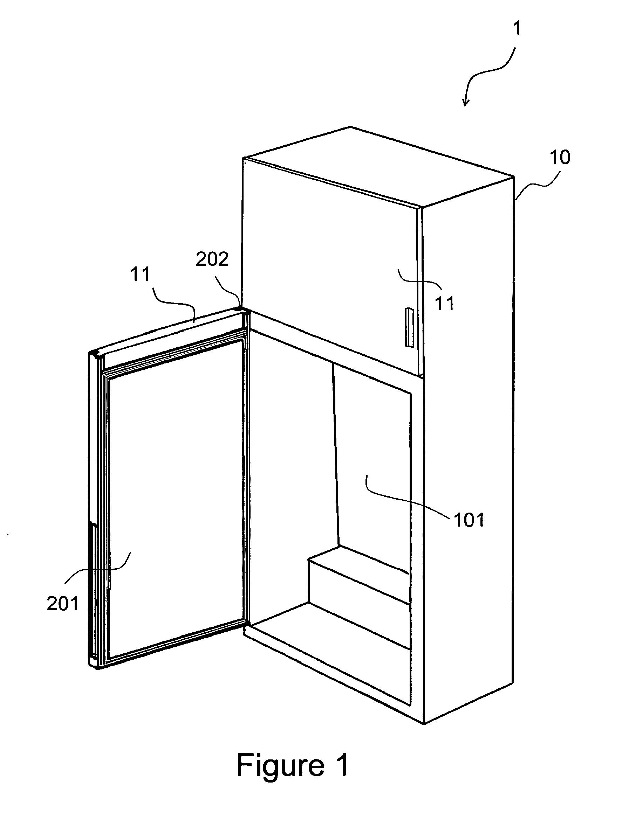

The present invention relates to coating of all surfaces (203), which are in contact to the ambient air (a), by means of a graphene layer (30) in order to prevent rusting of metal materials (20) like a metal plate (201) or a metal piece (202) used in formation of some sections of the home appliance (1) and in order to provide long life to said metal materials (20) (Figure 1, 2, 3).

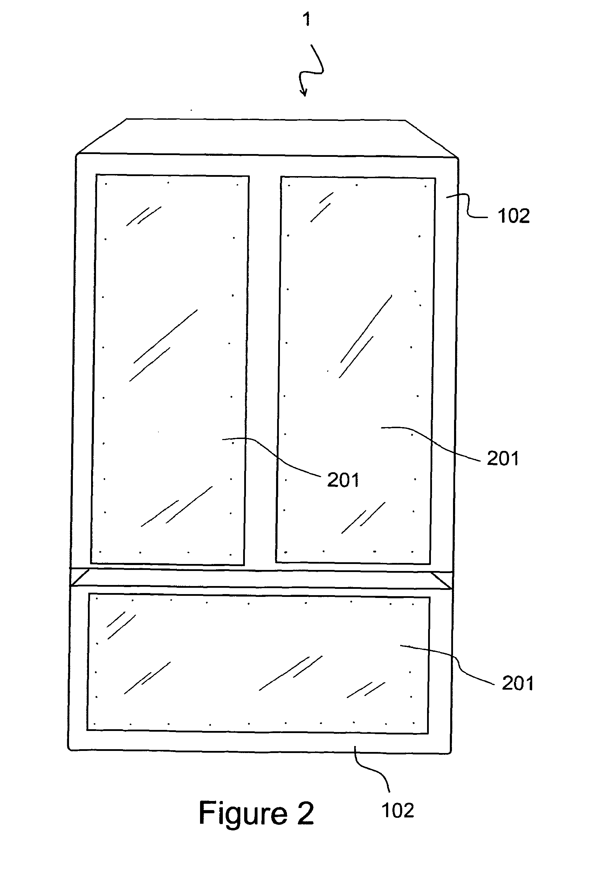

A body (10) of the home appliance (1) essentially comprises an inner liner (101) forming an inner section of the body (10), and an outer liner (102) covering the body (10) from front, lateral, upper and rear sections. At a front section of the body (10), at least one door (11) is configured in an openable-closeable manner so as to provide access to the inner sections of the body (10) (Figure 1). A hinge is used in order for the door (11) to be openable-closeable. Hinges are in general metal pieces (202) for carrying the load applied thereon. Metal plates (201) forming the inner liner (101) and/or outer liner (102) of the home appliance (1) are aluminum sheet, steel sheet or galvanize-coated metal sheet (Figure 2).

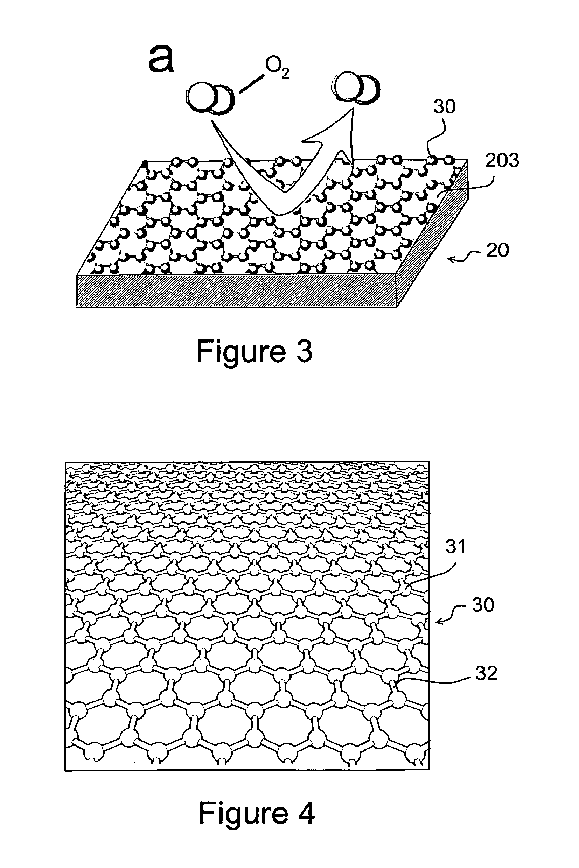

Graphene is a carbon allotrope like diamond. In this material, carbon atoms (31) are arranged by forming a hexagonal bond (32) (Figure 3, 4). In the crystal structure having a honey comb view, the main constituent of graphite, nano-tube and C₆₀ is graphene which realizes sp² hybridization. Graphene is one of the rarest examples of two-dimensional planar structures. The carbon atoms (31) realize sp² hybridization with angle of 120 degrees by means of the combination of 1s and 2p orbitals, and the free p_{z} orbitals provide extraordinary properties to the graphene material. While the carbon nano-tubes and C₆₀ molecules can be synthesized only by means of artificial methods, diamond and graphite can exist in a free manner in nature. The reason of the stable structure of graphene is the thermal fluctuations which are orthogonal with respect to the surface. In the single or multi-layer form, it is transparent. Therefore, it completely reflects the visual properties of the metal material (20) whereon it is coated.

The coating of the metal materials (20) of the subject matter home appliance (1) by means of graphene is as follows. The whole of the visible surfaces (203) of the metal materials (20) is coated with a graphene layer (30), having at least one layer, by means of the Chemical Vapor Precipitation Method. In order for this method to be applied, the appropriate ambient conditions shall be formed. For instance, the ambient air (a) is brought to values in the temperature range 650° to 1000° C. The temperature development range depends on the surface selection and on the carbon source. The required ambient conditions can be provided in a Chemical Vapor Precipitation unit having a closed ambient. The metal material (20) is placed inside this unit, and all of the visible surfaces (203) are coated with graphene layer (30).

The steps of the method related to formation of the graphene layer (30) on the surface (203) of the metal material (20) are as follows: First of all, Graphene is brought to gas phase inside the hot ambient air (a). The metal material (20) is heated inside the same ambient air (a). By means of the Chemical Vapor Precipitation method, Graphene, which has been brought to gas phase, is precipitated by means of the Oxygen atoms provided in the air. The place, where Graphene is precipitated in gas phase, is the surface (203) of the metal material (20). Inside this ambient, the oxygen atoms in gas form provide the carbon atoms (31) to hold onto the surface (203) of the metal material (20). Afterwards, after the oxygen atoms leave the carbon atoms (31) onto the surface (203) of the metal material (20), they re-mix to the ambient air (a). This results from the fact that the surface (203) of the metal material (20) is hot and that the oxygen atoms are diverged by means of this. The carbon atoms (31) are formed in a hexagonally arranged manner. By means of the chemical vapor precipitation method, a graphene layer (30) can be obtained with desired thickness as nanometer or micrometer. Pluralities of precipitation processes are repeated, and pluralities of graphene layers (30) can be obtained.

The metal material (20) with graphene layer (30) is formed in a corrosion-resistant manner. Cyclic voltammetry is a potential-dynamic electrochemical measurement type. The resistance of the graphene layered (30) metal material (20) against corrosion is tested with cyclic voltammetry and measured. As a result of the test, no damage is observed on the surface (203) of the graphene-layered (30) metal material (20).

In an alternative production method of the present invention, gases including other atoms instead of oxygen can be used which will provide the carbon atoms (31) to be held and precipitated onto the surface (203). The other atoms are the atoms whose molecular weight is greater than the weight of the carbon atom (31).

In an alternative production method of the present invention, the surface (203), whereon the carbon atoms (31) are held and forming the graphene layer (30), can be a metal material (20) surface comprising a copper, a Ni-Cu alloy, an Al, a Ni-Cr-Fe alloy or a Cr-Fe alloy.

### REFERENCE NUMBERS

**1.** Home appliance
**10**. Body
**101.** Inner liner
**102.** Outer liner
**11**. Door

**20.** Metal material
**201.** Metal plate
**202.** Metal piece
**203.** Surface

**30.** Graphene layer
**31.** Carbon atom
**32**. Bond

**a.** Ambient air

## Claims

1. A home appliance (1), and particularly a cooling device having metal materials (20) in metal plate (201) form or in metal piece (202) form, **characterized in that** it comprises at least one graphene layer (30) coated onto the at least one surface (203) of said metal material (20) and made of carbon atoms (31).

2. The home appliance (1) according to claim 1; wherein the graphene layer (30) comprises six carbon atom (31) arrangements with hexagonal shape and having one each bonds (32) in between the carbon atoms (31).

3. The home appliance (1) according to any one of the preceding claims; wherein the metal material (20) comprises a multi-layer graphene layer (30).

4. The home appliance (1) according to any one of the preceding claims; wherein the metal materials (20) are the metal plates (201) forming an inner liner (101) of the home appliance (1).

5. The home appliance (1) according to any one of the preceding claims; wherein the metal materials (20) are the metal plates (201) forming an outer liner (102) of the home appliance (1).

6. The home appliance (1) according to any one of the preceding claims; wherein the metal material (20) is a metal piece (202) forming the sections of the home appliance (1), for example, a hinge or a decorative panel.

7. The home appliance (1) production method and particularly a cooling device production method having metal materials (20) in metal plate (201) or metal piece (202) form; wherein in order to provide an efficient stainlessness to metal materials (20), at least one surface (203) of the metal material (20) is coated with at least one graphene layer (30).

8. The method for obtaining a metal material (20) coated with a graphene layer (30) according to Claim 7; wherein it comprises the process steps of obtaining carbon atoms (31) in gas form by heating the ambient air (a), heating the surface (203) of the metal material (20), providing the carbon atoms (31) to be held by precipitating carbon (31) atoms onto the surface (203) of the metal material (20) in the same ambient, and by means of one each bond (32) in between the carbon atoms (31).

9. The method for obtaining a metal material (20) coated with a graphene layer (30) according to Claim 8; wherein the ambient air (a), where the carbon atoms (31) and metal material (20) are provided, is heated to a temperature between 650 and 1000 °C.

10. The method for obtaining a metal material (20) coated with a graphene layer (30) according to Claim 7 and 8; wherein it comprises the process step of cooling the surface (203) of the metal material (20).
